**Europäisches Patentamt**

**European Patent Office**

**Office européen des brevets**

(19)

(11) Veröffentlichungsnummer: **0 197 589**
**A2**

(12) # EUROPÄISCHE PATENTANMELDUNG

(21) Anmeldenummer: 86200505.5

(22) Anmeldetag: 26.03.86

(51) Int. Cl.⁴: **G 01 N 24/04**

(30) Priorität: 30.03.85 DE 3511750

(43) Veröffentlichungstag der Anmeldung:
15.10.86 Patentblatt 86/42

(84) Benannte Vertragsstaaten:
CH DE FR GB LI NL

(71) Anmelder: **Philips Patentverwaltung GmbH**
**Billstrasse 80**
**D-2000 Hamburg 28(DE)**

(84) Benannte Vertragsstaaten:
**DE**

(71) Anmelder: **N.V. Philips' Gloeilampenfabrieken**
**Groenewoudseweg 1**
**NL-5621 BA Eindhoven(NL)**

(84) Benannte Vertragsstaaten:
**CH FR GB LI NL**

(72) Erfinder: **Röschmann, Peter**
**Steenbalken 13**
**D-2000 Hamburg 63(DE)**

(74) Vertreter: **Hartmann, Heinrich, Dipl.-Ing.**
**Philips Patentverwaltung GmbH Billstrasse 80 Postfach**
**10 51 49**
**D-2000 Hamburg 28(DE)**

(54) **Spulenanordnung für Kernspinunterschungen.**

(57) Die Erfindung betrifft eine Spulenanordnung für Kernspinuntersuchungen, deren Leiteranordnung von einer zylinderförmigen Abschirmung umschlossen wird. Durch zusätzliche Abschirmungen, die die Öffnungen der Spulenanordnung zum Einführen des Patienten ganz oder teilweise umschließen, wird erreicht, daß das magnetische Feld in Längsrichtung der Spule weitgehend konstant ist.

Fig.5

EP 0 197 589 A2

BESCHREIBUNG

"Spulenanordnung für Kernspinuntersuchungen"

Die Erfindung betrifft eine Spulenanordnung für Kernspinuntersuchungen zum Erzeugen und/oder Empfangen hochfrequenter Magnetfelder mit einer Öffnungen zum Einführen
eines zu untersuchenden Körpers aufweisenden Leiteranordnung und einer sie umschließenden zylinderförmigen,
elektrisch leitenden und mit Masse verbundenen
Abschirmung.

Eine solche Spulenanordnung ist aus Program and Book of
Abstracts, Society of Magnetic Resonance in Medicine,
third annual meeting, August 13-17, 1984, New York,
bekannt.

Bei einer Kernspinuntersuchung wird ein zu untersuchender
Körper, beispielsweise ein Patient, einem starken
homogenen statischen Magnetfeld ausgesetzt. Die darin
enthaltenen Atomkerne weisen aufgrund ihres Kernspins ein
magnetisches Moment auf, das mit einer von der Art des
Atomkerns und von der Stärke des statischen Magnetfeldes
abhängigen Frequenz, der sogenannte Larmorfrequenz, um die
Richtung des statischen Magnetfeldes präzediert. Die
Larmorfrequenz ist der magnetischen Induktion des
statischen Magnetfeldes proportional, wobei der Proportionalitätsfaktor durch das sogenannte gyromagnetische
Verhältnis gegeben ist; es beträgt für Wasserstoff
beispielsweise etwa 42,57 MHz/T.

Wirkt auf den Körper, der dem statischen Magnetfeld
ausgesetzt ist, ein dazu senkrechtes hochfrequentes
Magnetfeld ein, dessen Frequenz der Larmorfrequenz entspricht, tritt eine Kernspinresonanz auf, wobei die präzedierenden Kerne dem hochfrequenten Magnetfeld Energie entnehmen, die sie nach dem Abschalten des Magnetfeldes in Form einer elektromagnetischen Welle mit der Larmorfrequenz wieder abstrahlen.

Die Spulenanordnung der eingangs genannten Art dient der Erzeugung des hochfrequenten Feldes bzw. dem Empfang der nach dem Abschalten des Feldes auftretenden Kernspinresonanzsignale. Sie besitzt z.B. vier geradlinige, in Richtung des statischen Magnetfeldes - der z-Richtung eines Kartesischen Koordinatensystems - verlaufende Leiter, die in einem zur z-Richtung senkrechten Querschnitt auf den Eckpunkten eines Rechteckes bzw. auf dem Umfang eines Kreises angeordnet sind. Alle vier Leiter werden bei der Erzeugung eines hochfrequenten Magnetfeldes von hochfrequenten Strömen gleicher Amplitude durchflossen, wobei jedoch die Ströme in diagonal einander gegenüberliegenden Leitern einander entgegengesetzt sind. Im Zentrum dieser vier Leiter ergibt sich dabei ein relativ homogenes Magnetfeld.

Bei der bekannten Spulenanordnung werden die vier Leiter von einer zylinderförmigen Abschirmung umschlossen, deren Symmetrieachse in z-Richtung verläuft. Dadurch wird die Leiteranordnung von der Umgebung außerhalb der Abschirmung weitgehend entkoppelt, so daß einerseits äußere magnetische Störfelder die Signale in den Leitern kaum beeinflussen und andererseits die Induktivität der Spulenanordnung weitgehend unabhängig ist von ihrem jeweiligen Aufstellungsort. Dabei ist noch anzumerken, daß bei höheren Frequenzen die Abmessungen der Leiter nicht mehr vernachlässigbar klein gegenüber der Wellenlänge sind, so daß es sich nicht mehr um eine konzentrierte Induktivität handelt.

Untersuchungen haben nun ergeben, daß die magnetische Induktion in dem Hochfrequenzfeld von der z-Richtung abhängt. Sie nimmt von der Mitte ausgehend zu den Enden der Leiteranordnung hin ab. Die gleiche Abhängigkeit ergibt sich auch bei einer Sattelspule, wie sie aus der europäischen Patentanmeldung 83 201 449.2 bekannt ist.

Aufgabe der vorliegenden Erfindung ist es, eine Spulenanordnung zu schaffen, bei der die magnetische Induktion weniger stark von der z-Richtung abhängt als bei den bekannten Spulen.

Diese Aufgabe wird ausgehend von einer Spulenanordnung der eingangs genannten Art erfindungsgemäß dadurch gelöst, daß zumindest eine der Öffnungen der Leiteranordnung ganz oder teilweise mit einer zusätzlichen Abschirmung versehen ist, die elektrisch leitend mit der zylinderförmigen Abschirmung verbunden ist.

Dadurch, daß die - in z-Richtung gegeneinander versetzten - Öffnungen durch die zusätzliche Abschirmung ganz oder teilweise abgeschirmt werden, ergibt sich gegenüber dem nicht abgeschirmten Zustand an den Enden der Leiteranordnung, d.h. im Bereich der Öffnungen, eine Konzentration des Magnetfeldes, die dazu führt, daß die magnetische Induktion innerhalb der Leiteranordnung nur noch in geringem Maße von der z-Richtung abhängt.

Weitere Ausgestaltungen und Vorteile der Erfindung werden nachfolgend anhand der Zeichnung näher erläutert. Es zeigen:

Fig. 1 Kernspintomographiegerät in schematischer Darstellung zusammen mit dem Verlauf der magnetischen Induktion in z-Richtung,

Fig. 2a und b den Verlauf der magnetischen Feldlinien bei einer Spulenanordnung nach dem Ringresonatorprinzip ohne die zusätzliche Abschirmung,

Fig. 3 den Verlauf der magnetischen Feldlinien bei der gleichen Spule mit zusätzlicher Abschirmung,

Fig. 4 die Abhängigkeit der magnetischen Induktion von der z-Richtung,

Fig. 5 und 6 verschiedene Ausgestaltungsmöglichkeiten der Abschirmung und

Fig. 7 eine erfindungsgemäß ausgestaltete Sattelspule.

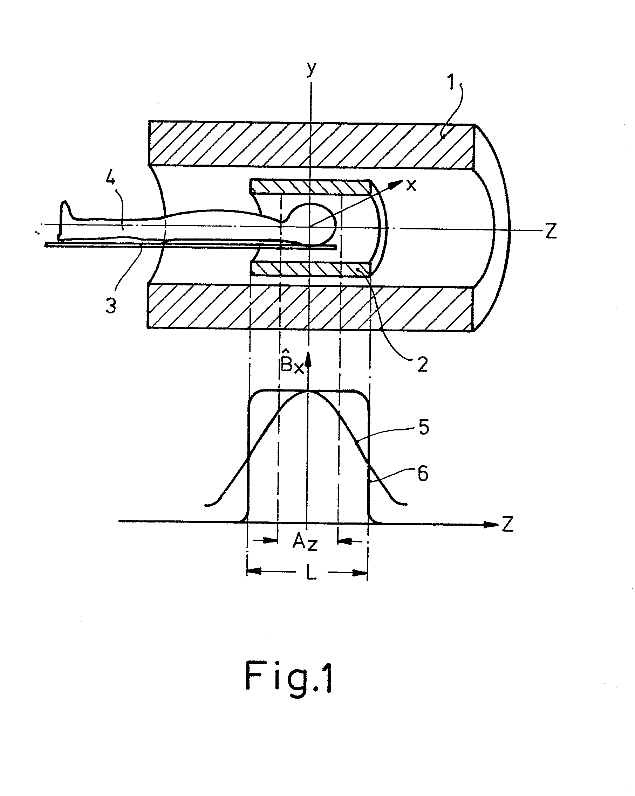

Fig. 1 zeigt in schematischer Darstellung einen Längsschnitt durch einen Kernspintomographen, wobei nur der Magnet 1 zur Erzeugung des homogenen statischen Feldes, die Spule 2 zur Erzeugung und zum Empfangen des hochfrequenten magnetischen Feldes und eine Liege 3, auf der sich ein Patient 4 befindet, dargestellt sind. Die übrigen Bestandteile eines solchen Gerätes wie Gradientenspulen und dergl. sind zwecks besserer Übersicht nicht dargestellt. Der Hauptmagnet 1 ist koaxial zu einer z-Achse angeordnet und in ihrer Mitte befindet sich - ebenfalls koaxial zur z-Achse - die Hochfrequenzspule 2. Das von ihr erzeugte Magnetfeld verläuft senkrecht zur z-Achse, d.h. im wesentlichen in x-Richtung eines Kartesischen Koordinatensystems.

Unterhalb dieser schematischen Darstellung ist der Verlauf der magnetischen Induktion B als Funktion der z-Koordinate durch die glockenförmige Kurve 5 dargestellt. Man erkennt eine starke z-Abhängigkeit. Es kommt noch erschwerend hinzu, daß bei Verwendung der Hochfrequenzspule zum Empfang der Kernresonanzsignale die dadurch in der Spule induzierten Signale um so kleiner sind, je weiter sie von dieser Ebene entfernt sind. Dies führt dazu, daß bei der Aufnahme eines Tomogramms in einer die z-Achse enthaltenden Schicht mit einem derartigen Gerät die Bildhelligkeit mit zunehmendem Abstand von der das Feldstärkemaximum definierenden xy-Ebene abnimmt.

Dieser Nachteil wird üblicherweise dadurch beseitigt, daß die Länge L der Hochfrequenzspule 2 größer als die gewünschte Abbildungslänge $A_z$ in z-Richtung gewählt wird, z.B. doppelt so groß, so daß nur die relativ gute Homogenität der Magnetfeldstärke im Zentralbereich für die Bildgebung benutzt wird. Nachteilig ist dabei jedoch, daß auch die Teile des Patienten, die bei der Abbildung nicht erfaßt werden, einer nennenswerten Hochfrequenzenergie ausgesetzt werden, so daß die vom Patienten insgesamt absorbierte Hochfrequenzleistung zunimmt und die Resonanzgüte der mit dem Patienten belasteten Hochfrequenzspule unnötig stark abnimmt. Ferner machen sich bei größeren Baulänge der Hochfrequenzspule Wellenausbreitungseffekte bemerkbar und der Abstand der Betriebsfrequenz von der Eigenresonanzfrequenz verringert sich. Dadurch treten unerwünschte elektrische HF-Felder im Patientenbereich der Spule auf, die zusätzlich HF-Absorption im Patienten und daraus resultierend eine weitere Abnahme der Resonanzgüte der mit dem Patienten belasteten Spule bewirken.

Die Kurve 6 bezeichnet den idealen (rechteckigen) Verlauf der Feldstärke in z-Richtung. Man erkennt, daß die Feldstärke praktisch über die gesamte Spulenlänge konstant ist, so daß die ausnutzbare Länge $A_z$ der Spule ihrer Länge L entspricht.

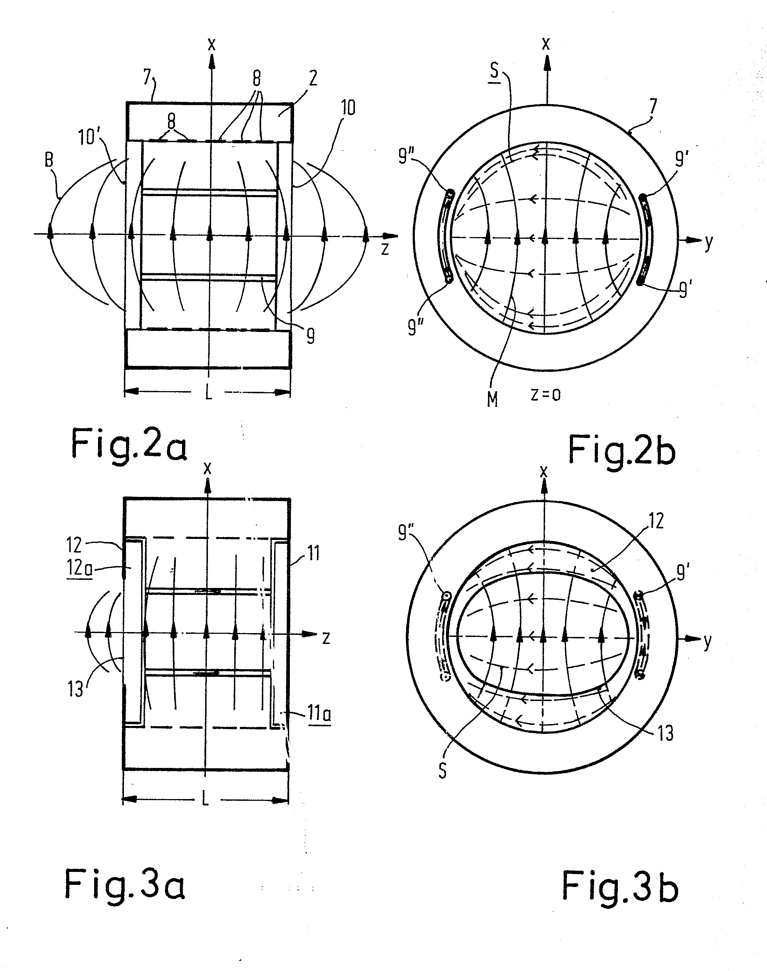

Fig. 2a zeigt einen Querschnitt der bekannten Hochfrequenzspule in einer x-z-Ebene, während die Fig. 2b einen Querschnitt in der xy-Ebene im Zentrum (z = 0) zeigt. Wie aus Fig. 2a und Fig. 2b zu entnehmen ist, umfaßt die Leiteranordnung der Spule vier sich in z-Richtung erstreckende Leiter 9' und 9", die auf den Eckpunkten eines Rechteckes bzw. auf dem Umfang eines Kreises angeordnet sind. Diese Leiter werden bei der Erzeugung eines Magnetfeldes von Hochfrequenzströmen gleicher Amplitude durchflossen, wobei der Strom in dem Leiterpaar 9' die entgegengesetzte Richtung hat wie in dem Leiterpaar 9". Die Leiteranordnung befindet sich auf einem nicht näher dargestellten, zur z-Achse koaxialen Hohlzylinder aus Kunststoff, der etwas länger ist als die Leiteranordnung und der über ebenfalls nicht dargestellte isolierende Verbindungsstege mit einem zweiten Hohlzylinder aus Kunststoff mit größerem Durchmesser verbunden ist. Auf dem inneren oder äußeren Umfang dieses zweiten Zylinders ist eine zylinderförmige Abschirmung 7 angebracht aus einem elektrisch gut leitenden nicht ferromagnetischen Material, z.B. aus Kupferfolie oder einem Drahtgeflecht. Die Abschirmung 7 ist mit Masse verbunden ebenso wie die leitenden Ringe 8 auf der Innenseite oder Außenseite des nicht dargestellten, die Leiteranordnung 9', 9" tragendenHohlzylinders, die dazu dienen, das von der Leiteranordnung in ihrem Innern und im Bereich der Verbindungsbögen zwischen den Leitern 9', 9' einerseits und 9", 9" andererseits erzeugte, in z-Richtung verlaufende Magnetfeld sowie elektrische Felder im Untersuchungsbereich zu unterdrücken.

Insoweit als bisher beschrieben ist die Spulenanordnung Gegenstand der älteren europäischen Patentanmeldung 84 201 869.9.

In die Fig. 2a und 2b ist außerdem der Verlauf der magnetischen Feldlinien eingezeichnet. Da die Anordnung symmetrisch sowohl in bezug auf die z-Achse als auch in bezug auf die Mittelebene (z = 0) ist, resultiert daraus ein symmetrischer Feldlinienverlauf, jedoch wird das Magnetfeld im Bereich der Spulenöffnungen 10, 10' an den

0197589

Enden der Leiteranordnung, d.h. bei $z = \pm L/2$ nach außen "ausgebeult". Es ergibt sich also in diesen Bereichen eine geringere Feldliniendichte, d.h. eine geringere Magnetfeldstärke als im Zentrum ($z = 0$) der Spule. - In Fig. 2b sind gestrichelt noch Linien S eingezeichnet, die senkrecht zur Richtung des Magnetfeldes M verlaufen.

Die in Fig. 3a und 3b dargestellte erfindungsgemäße Spulenanordnung entspricht der in Verbindung mit Fig. 2 beschriebenen Spulenanordnung, jedoch ist die Öffnung 10 durch eine Abschirmung 11 vollständig und die Öffnung 10' durch eine Abschirmung 12 abgeschlossen, die mit einer Öffnung 13 versehen ist, deren Fläche deutlich kleiner ist als die der Öffnung 10 - z.B. um mindestens 10 %.

Die Abschirmungen 11 und 12 bestehen ebenso wie die Abschirmung 7 aus elektrisch gut leitendem nicht-ferromagnetischem Material, z.B. einer Kupferfolie oder einem Geflecht aus Kupferdrähten, die zweckmäßigerweise auf ebenen Kunststoffscheiben 11a und 12a jeweils gleicher Größe angeordnet sind und die elektrisch leitend mit der Abschirmung 7 verbunden sind. Die beiden zusätzlichen Abschirmungen 11 und 12 befinden sich somit in zur z-Achse senkrechten Ebenen.

Da sich somit in unmittelbarer Nähe insbesondere des rechten Endes der Spule durch die Anbringung der zusätzlichen Abschirmung 11 eine leitende Ebene befindet, kann das Magnetfeld in diesem Bereich ebenfalls nur parallel zur leitenden Ebene verlaufen, während hier senkrecht zu den Schirmen gerichtete Magnetfeldkomponenten nicht auftreten können. Die zur Oberfläche der zusätzlichen Abschirmung 11 parallelen Magnetfeldkomponenten rufen in dieser Ströme hervor, die den in Fig. 3b mit S bezeichneten Verlauf haben, der weitgehend demjenigen der Linie S nach Fig. 2b entspricht. Somit ergibt sich am rechten Ende der Spule nach Fig. 3 ein Magnetfeldverlauf, der weitgehend demjenigen in der Mitte entspricht.

Auf der linken Seite sind die Verhältnisse nicht ganz so günstig, weil in der Abschirmung 12 eine Öffnung 13 zum Einführen des Patienten vorgesehen sein muß. Durch diese Öffnung kann das Magnetfeld nach außen dringen, jedoch nicht so ausgeprägt wie bei Fig. 2, weil die Öffnung kleiner ist als die durch die Leiteranordnung 9', 9" definierte Öffnung.

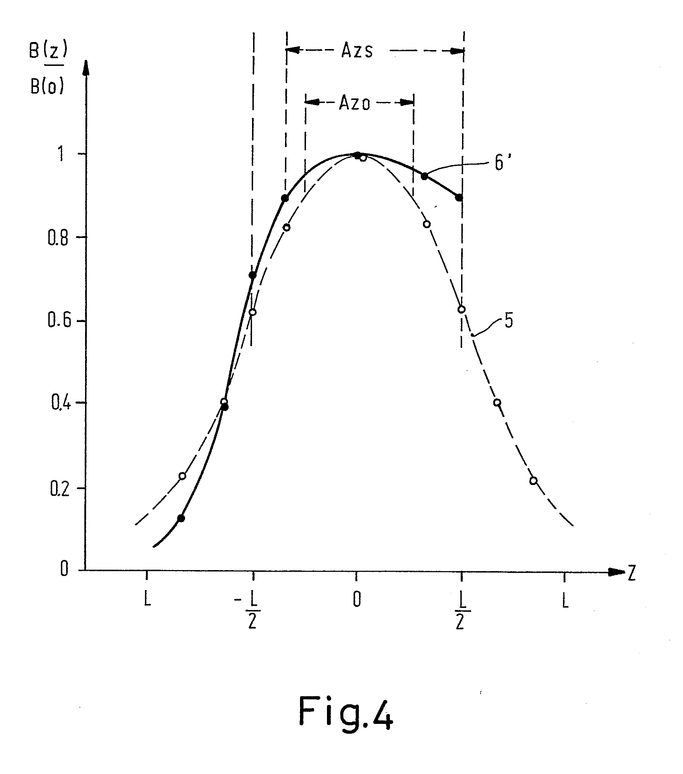

In Fig. 4 ist der Verlauf der magnetischen Induktion $B(z)$ längs der z-Achse, bezogen auf das Maximum $B(o)$ der magnetischen Induktion in der Mittelebene ($z = 0$) dargestellt, und zwar für die Spulen nach Fig. 2 und Fig. 3. Dabei zeigt die Kurve 5 den Verlauf bei der Spule nach Fig. 2 und die Kurve 6' den Verlauf bei der Spule nach Fig. 3, d.h. mit den Schirmen 11 und 12. Man erkennt, daß der Bereich $A_{zo}$, in dem die Spule nach Fig. 2 einen Abfall der magnetischen Induktion von weniger als 10 % aufweist, etwa zwischen $z = - L/4$ und $z + L/4$ liegt, während bei der Spule nach Fig. 3 dieser Bereich zwischen $z = - L/3$ und $z = + L/2$ liegt. Das bedeutet, daß die erfindungsgemäße Spule bei gleicher Spulenlänge einen wesentlich größeren ausnutzbaren Bereich für Abbildungen in der x-z-Ebene bzw. der y-z-Ebene hat als die bekannte Spule nach Fig. 2 bzw. daß die erfindungsgemäße Spule wesentlich kürzer sein kann als die bekannte Spule, wenn in diesen Ebenen ein definierter Bereich mit gleicher Abbildungsqualität erfaßt werden soll. Es kommt hinzu, daß das Maximum der Induktion $B(o)$ in der Mittelebene ($z = 0$) bei einer Spule nach Fig. 3 größer ist als bei einer Spule nach Fig. 2. Beide Effekte führen dazu, daß bei der erfindungsgemäßen Spule weniger Energie erforderlich ist als bei der bekannten Spule, um den Vektor der Kernmagnetisierung mittels des Hochfrequenzfeldes um einen definierten Winkel kippen zu lassen.

Ein weiterer Vorteil der durch die Verwendung der zusätzlichen Abschirmungen 11 und 12 möglichen Verkürzung ergibt sich bei großen statischen Magnetfeldern bzw. bei hohen Larmorfrequenzen. Bei hohen Frequenzen ist die Hochfrequenzstromamplitude als Folge der Wellenausbreitung nicht mehr über die gesamte Länge L der Leiter konstant. Wird die Spule beispielsweise so angeregt, daß in der Mitte ($z = 0$) ein Maximum des Stromes auftritt (Strombauch), dann fällt die Amplitude des Stromes und mit ihr auch die Amplitude der magnetischen Induktion zu den Leiterenden hin ab, was eine zusätzliche Abnahme der magnetischen Induktion im Bereich der Öffnungen bewirkt. Wenn die Spulen jedoch kürzer gehalten werden können, ist die dadurch bewirkte Abnahme geringer.Außerdem wird der Einfluß externer elektromagnetischer Störfelder noch weiter verringert.

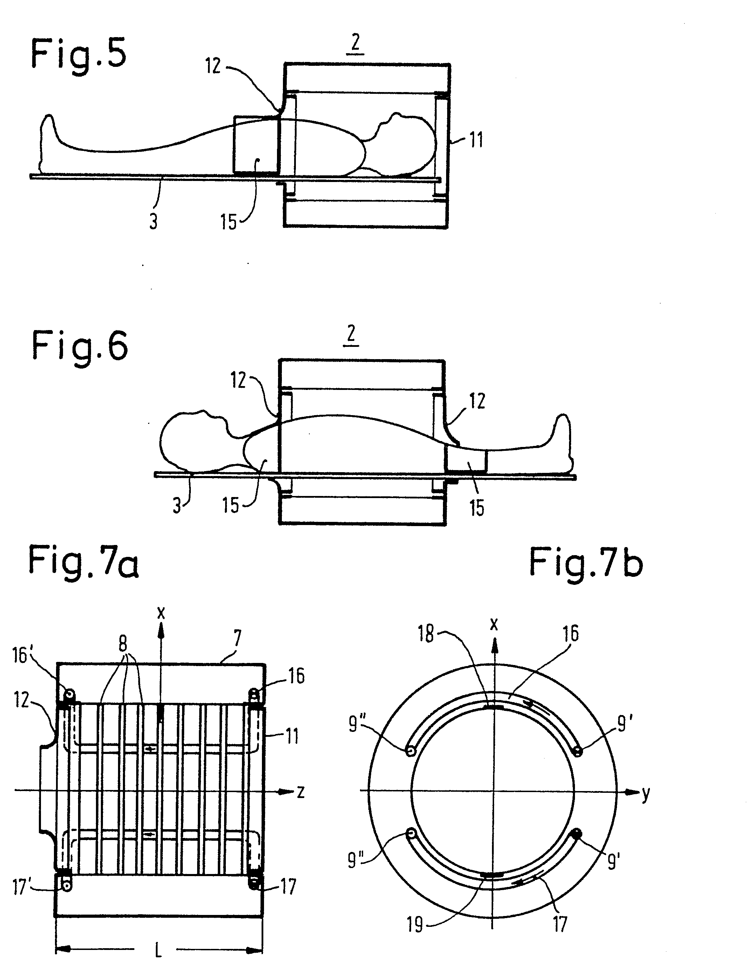

Wie aus Fig. 5 hervorgeht, kann der Kopf oder der obere Brustbereich eines Patienten untersucht werden, wenn auf der einen Seite der geschlossene Schirm 11 und auf der anderen Seite der mit einer Öffnung versehene Schirm 12 verwendet wird. Um das Herausdrängen des Magnetfeldes aus den Öffnungsbereich zu verringern, ist mit der mit der Öffnung versehenen Abschirmung eine weitere flexible ringförmige Abschirmung 15 vorgesehen, die nach dem Einbringen des Patienten mit der Abschirmung 12 durch Steck- oder Klemmverbindungen elektrisch leitend verbunden wird. Soll der Patient im mittleren oder unteren Rumpfbereich untersucht werden, ist eine Spule erforderlich, die beidseitig mit Öffnungen versehene Abschirmungen 12 aufweist, an die dann ggf. noch ein ringförmiger Schirm 15 angeschlossen

0197589

werden kann (Fig. 6). Um in diesem Fall das Auswechseln der Spulen zu vermeiden, ist es zweckmäßig, zumindest die Abschirmung 11 als herausnehmbaren Einsatz auszugestalten, so daß sie lediglich gegen eine Abschirmung 12 mit Öffnung ausgetauscht werden muß.

Die leitenden Verbindungen zwischen der ringförmigen Abschirmung 15 und der Abschirmung 12 kann an der Unterseite durch in der Patientenliege 3 an verschiedenen Ebenen angebrachten Durchführungskontaktreihen erfolgen, die auf der Unterseite des Bettes 3 in vorgegebene Kontaktstellen einrasten und auf der Oberseite mit dem ringförmigen Schirm Kontakt haben.

Wenn der in Bild 3b gezeigte Schirmstromverlauf S durch die Patientenliege 3 nicht wesentlich unterbrochen wird (dies kann z.B. durch Drehen der Spule 2 um 90° erreicht werden), kann auf eine leitende Verbindung zwischen den Abschirmungen 12 und 15 im Bereich der Patientenliege verzichtet werden.

Die flexiblen Abschirmungen 12 und 15 können aus textil- oder litzenartigen Kupfergeflechten hergestellt werden. Die Dicke der Abschirmungen sollte mindestens dem Dreifachen der Eindringtiefe bei der Frequenz des Magnetfeldes entsprechen und die Drähte bzw. Folienstreifen, aus denen die Abschirmungen hergestellt werden können, sollten vorzugsweise in Richtung der Linien 2b und 3b verlaufen, d.h. senkrecht zur Richtung des Hochfrequenzmagnetfeldes bzw. annähernd in y-Richtung.

Um das Magnetfeld zu homogenisieren, ist es von Nutzen, die Abschirmung 7 so zu gestalten, daß sie auch die Stirnflächen zwischen den zylinderförmigen Teilen dieser Abschirmung und den Abschirmungen 11 und 12 abschließt.

In Fig. 7a und 7b ist im Längs- bzw. Querschnitt eine Einheit zur Erzeugung eines hochfrequenten Magnetfeldes mittels einer Sattelspule dargestellt. Diese Sattelspule umfaßt ebenfalls vier Leiter, die auf den Eckpunkten eines Rechteckes angeordnet sind, wobei einander diagonal gegenüberliegende Leiter jeweils von einem Strom gleicher Größe, jedoch entgegengesetzter Polarität durchflossen werden. Die jeweils zwei Leiter miteinander verbindenden Verbindungsbögen 16, 17 bzw. 16', 17' verbinden hier jedoch Leiter (z.B. 9', 9"), die in entgegengesetzter Richtung vom Strom durchflossen werden. Eine äußere Abschirmung 7 umschließt die Sattelspule einschließlich der bogenförmigen Verbindungsleitungen 16, 16' und 17, 17'. Die Spulenöffnungen werden durch die vorzugsweise herausnehmbaren Abschirmungen 11 bzw. 12 ganz bzw. teilweise verschlossen, wodurch erreicht wird, daß wie bei der Einheit nach Fig. 3 die magnetische Induktion in Richtung der z-Achse sich nur relativ schwach ändert. Besonders günstig wirkt sich auch hier ein im Spuleninnern befindlicher Faraday-Schirm aus, der geschlossene ringförmige Streifen 8 umfaßt, die auf gegenüberliegenden Seiten jeweils unterhalb der Mitte der bogenförmig Verbindungsleitungen 16, 16' und 17, 17' durch die Verbindungsstreifen 18, 19 (vgl. Fig. 7b) mit dem äußeren Hochfrequenzschirm verbunden sind.

PATENTANSPRÜCHE

1.    Spulenanordnung für Kernspinuntersuchungen zum
Erzeugen und/oder Empfangen hochfrequenter Magnetfelder
mit einer Öffnungen zum Einführen eines zu untersuchenden
Körpers aufweisenden Leiteranordnung und einer sie umschließenden zylinderförmigen elektrisch leitenden und mit
Masse verbundenen Abschirmung,
dadurch gekennzeichnet, daß zumindest eine der
Öffnungen (10, 10') der Leiteranordnung (9, 9') ganz oder
teilweise mit einer zusätzlichen Abschirmung (11, 12)
versehen ist, die elektrisch leitend mit der zylinderförmigen Abschirmung (7) verbunden ist.

2.    Spulenanordnung nach Anspruch 1,
dadurch gekennzeichnet, daß die zusätzliche Abschirmung
(11) eine der beiden Öffnungen (10') der Leiteranordnung
vollständig abschließt.

3.    Spulenanordnung nach einem der Ansprüche 1 oder 2,
dadurch gekennzeichnet, daß die zusätzliche
Abschirmung (12) mit einer Öffnung (13) zum Einführen des
Patienten versehen ist, die kleiner ist als die
Öffnung (10) der Leiteranordnung (9, 9').

4.    Spulenanordnung nach einem der vorhergehenden
Ansprüche,
dadurch gekennzeichnet, daß die zusätzliche
Abschirmung (11, 12) sich im wesentlichen in einer zur
Längsachse der zylindrischen Abschirmung senkrechten Ebene
erstreckt.

5. Spulenanordnung nach Anspruch 2 oder 3, dadurch gekennzeichnet, daß die zusätzliche Abschirmung (11, 12) als herausnehmbarer Einsatz ausgebildet ist.

6. Spulenanordnung nach Anspruch 3, dadurch gekennzeichnet, daß an der Öffnung der zusätzlichen Abschirmung ein flexibler Schirm (15) angebracht ist, der mit der zusätzlichen Abschirmung elektrisch leitend verbunden ist.

7. Spulenanordnung nach einem der vorhergehenden Ansprüche, dadurch gekennzeichnet, daß die Leiteranordnung als Sattelspule ausgebildet ist (Fig. 7).

8. Spulenanordnung nach einem der Ansprüche 1 bis 6, dadurch gekennzeichnet, daß die Leiteranordnung als Ringresonator ausgebildet ist (Fig. 3).

Fig.1

0197589

Fig.2a

Fig.2b

Fig.3a

Fig.3b

0197589

Fig.4

# Fig.5

# Fig.6

# Fig.7a

# Fig.7b